# EUROPÄISCHE PATENTSCHRIFT

(11) **EP 0 958 502 B1**
(45) Veröffentlichungstag und Bekanntmachung des Hinweises auf die Patenterteilung: **06.08.2003**
(21) Anmeldenummer: 98910585.3
(22) Anmeldetag: 06.02.1998
(51) Int. Cl.: G01R 33/09

(54) **MAGNETISCHER MESSFÜHLER**
MAGNETIC SENSOR
CAPTEUR MAGNETIQUE

(30) Priorität: 09.02.1997 DE 19706012
(43) Veröffentlichungstag der Anmeldung: 24.11.1999
(73) Patentinhaber: Hahn-Meitner-Institut Berlin Gesellschaft mit beschränkter Haftung, 14109 Berlin (DE)
(72) Erfinder: KLOSE, Frank, D-01069 Dresden (DE); MALETTA, Hansjörg, D-14199 Berlin (DE); NAGENGAST, Dieter, D-96103 Hallstadt (DE); REHM, Christine, D-01069 Dresden (DE); WEIDINGER, Alois, D-14163 Berlin (DE)
(74) Vertreter: Rudolph, Margit
(86) Internationale Anmeldenummer: DE9800316
(87) Internationale Veröffentlichungsnummer: WO98035240

(56) Entgegenhaltungen:
- KLOSE F ET AL: "Continuous and reversible change of the magnetic coupling in an Fe/Nb multilayer induced by hydrogen charging" PHYSICAL REVIEW LETTERS, 10 FEB. 1997, APS, USA, Bd. 78, Nr. 6, 10. Februar 1997, Seiten 1150-1153, XP002073001 ISSN 0031-9007
- NAGENGAST ET AL.: "Hydrogen-induced change of the magnetic coupling in Nb/Fe multilayers" INTERNATIONAL SYMPOSIUM ON METAL-HYDROGEN SYSTEMS-FUNDAMENTALS AND APPLICATIONS, 25. - 30. August 1996, XP002073002 LES DIABLERETS, SWITZERLAND -& NAGENGAST D ET AL: "Hydrogen-induced change of the magnetic coupling in Nb/Fe multilayers" INTERNATIONAL SYMPOSIUM ON METAL-HYDROGEN SYSTEMS-FUNDAMENTALS AND APPLICATIONS, LES DIABLERETS, SWITZERLAND, 25-30 AUG. 1996, Bd. 253-254, Nr. 1-2, 20. Mai 1997, Seiten 347-349, XP002073003 ISSN 0925-8388, Journal of Alloys and Compounds, 20 May 1997, Elsevier, Switzerland
- WEIDINGER A ET AL: "Metallic multilayers and hydrogen" THIN SOLID FILMS, Bd. 275, Nr. 1, 1. April 1996, Seite 48-53 XP004006920

## Beschreibung

Die Erfindung betrifft einen magnetischen Messfühler mit durch Wasserstoffbeladung definiert veränderbarem internen - die Differenz des elektrischen Widerstandes bei angelegtem und abgeschaltetem Magnetfeld charakterisierenden - Magnetwiderstand, bestehend aus einem Multischichtpaket jeweils sich abwechselnder ferromagnetischer Schichten und wasserstoffaffiner nichtmagnetischer Zwischenschichten auf einem Substrat, wobei die Schichten und die Zwischenschichten magnetisch durch den Austausch spinpolarisierter Elektronen gekoppelt sind, und einer Deckschicht aus Pd zur Wasserstoffaktivierung.

Bei bestimmten magnetischen Schichtstrukturen hängt deren Magnetwiderstand sehr stark davon ab, ob die Magnetisierung benachbarter ferromagnetischer Schichten parallel oder antiparallel ist (Riesenmagnetowiderstandseffekt). Zwischen diesen Schichten kann über geeignete Zwischenschichten eine Kopplung durch den Austausch spinpolarisierter Elektronen bestehen. Durch unterschiedlich starke Reflexion der Elektronen mit "Spin auf" (Spin parallel zur Magnetisierung) und "Spin ab" (Spin antiparallel zur Magnetisierung) an den inneren Grenzflächen des Multischichtpakets ergibt sich ein Drehmoment für die Elementarmagnetisierungen, das für deren verschiedene Ausrichtungen sorgt. Als Auswirkung ergibt sich eine Beeinflussung der Kopplungsstärke zwischen den benachbarten ferromagnetischen Schichten und damit eine Beeinflussbarkeit des Magnetwiderstandes, d.h. des elektrischen Widerstandes, des gesamten Multischichtpakets. Die Magneteigenschaft des Multischichtpakets ändert sich zwischen ferromagnetisch und antiferromagnetisch. Dabei zeigt der Antiferromagnetismus durch eine Kompensation der resultierenden magnetischen Momente aufgrund der Antiparaltelstellungen keine spontane Magnetisierung mehr.

Die Kopplungsstärke zwischen den ferromagnetischen Schichten kann beispielsweise als Funktion der Zwischenschichtdicke eine gedämpfte Oszillation zwischen dem ferromagnetischen und dem antiferromagnetischen Zustand ausführen. Dabei wird jedoch durch die Wahl der Zwischenschichtdicke der Magnetwiderstand eines einzelnen Multischichtpakets festgelegt. Eine Veränderung, beispielsweise im Sinne einer Optimierung für den jeweiligen Anwendungsfall des magnetischen Messfühlers, ist nach dessen Herstellung nicht mehr möglich.

Neueste Veröffentlichungen (**Aufsatz I** : Thin Solid Films 275 (1996) 48-53, A. Weidinger et al., "Metallic multilayers and hydrogen" und **Aufsatz II** : Physica B 221 (1996) 377-381, Ch. Rehm et al., "Magnetic and structural properties of Fe/Nb multilayers") beschäftigen sich mit der Möglichkeit der Beeinflussung der magnetischen Austauschkopplung durch eine Beladung der nichtmagnetischen Zwischenschichten mit Wasserstoff aus der Gasphase.

Der **Aufsatz I,** von dem die Erfindung als nächstliegendem Stand der Technik ausgeht, beschreibt (ebenso wie die **Veröffentlichung** von N. Nagengast et al., "Hydrogen charging of Nb/Fe multilayers" in Journal of Alloys and Compounds 231 (1995) 307-309) vorbereitende Studien für die oben beschriebene Möglichkeit und kommt zu dem Ergebnis, dass sich zugeführter Wasserstoff in allen Zwischenschichten in dem stark wasserstoffaffinen Nb einlagern kann. Dieser Vorgang erfolgt kontinuierlich und prinzipiell reversibel. Insbesondere werden in diesem Aufsatz die Prozessparameter bei der Wasserstoffbeladung beschrieben. Diese sind in ihrer Größe äußerst moderat und deshalb leicht einzustellen. Weiterhin wird der realisierte Schichtenaufbau beschrieben. Wichtig für die Einlagerung von Wasserstoff ist dabei eine Pd-Schicht zur Aktivierung des Wasserstoffs, die als Deckschicht auf dem Schichtenpaket angeordnet wird. Die verwendeten Schichtdicken für Zwischenschichten aus Nb liegen unterhalb von 1,3 nm und oberhalb 2,3 nm. Pro Schichtenpaket sind alle Schichtdicken konstant. Der interne Magnetwiderstand ist im direkten Zusammenhang mit der möglichen Wasserstoffbeladung nur bei der Herstellung der Zwischenschichten durch die Wahl ihrer Schichtdicken festlegbar und damit nur von Schichtenpaket zu Schichtenpaket überhaupt definiert veränderbar. Nach der Herstellung des Schichtenpakets ist eine Veränderung des internen Magnetwiderstandes im Sinne einer Feinabstimmung nicht möglich. Eine Bestätigung der Theorie über die Möglichkeit einer kontinuierlichen und reversiblen Beeinflussung des Magnetwiderstandes zu dessen kontinuierlicher und reversibler Veränderung durch eine entsprechende Wasserstoffbeladung erfolgt nicht.

Auch im **Aufsatz II** wird dies nur als theoretische Möglichkeit beschrieben und kann experimentell auch bei einer Variation der Prozessparameter zwischen 200 °C und Raumtemperatur bzw. 10⁻⁵ mbar und Atmosphärendruck und einer jeweils konstanten Schichtdicke der Nb-Zwischenschichten von 1,3 nm, 1,7 nm und 2,3 nm nicht nachgewiesen werden. Eine Oszillation zwischen dem antiferromagnetischen und dem ferromagnetischen Grundzustand kann hier nur in Abhängigkeit von den unterschiedlichen Nb-Schichtdicken beobachtet werden.

Antiferromagnetisch geordnete Schichten besitzen einen Magnetwiderstand, der zur Messung von Magnetfeldem besonders geeignet ist. Im **Aufsatz III** : Phys. BI. 51 (1995) Nr.11, 1077-1081, P.Grünberg, "Riesenmagnetowiderstand in magnetischen Schichtstrukturen" wird die Einsatzmöglichkeit magnetischer Schichtstrukturen für magnetische Messfühler bei einer Variation der Zwischenschichtdicke beschrieben.

Die aus dem **Aufsatz III** bekannten magnetischen Messfühler, bei denen das Multischichtpaket in der bereits beschriebenen Weise aus mehreren ferromagnetischen Schichten aufgebaut ist, die zur Grundeinstellung des Magnetwiderstandes über nichtmagnetische metallische Zwischenschichten magnetisch miteinander austauschgekoppelt sind, dienen ausschließlich der Ermittlung von Änderungen des Magnetwiderstandes. Damit sind sie zum Einsatz als Feldsensoren geeignet. Sie können als Magnetköpfe zum Auslesen der Informationen auf magnetischen Informationsträgern dienen, andere zur Detektion von Position oder Geschwindigkeit, wenn die zu vermessenden Objekte ein Magnetfeld erzeugen können. Nur durch die Optimierung der Widerstandsänderung im Magnetfeld kann eine präzise Auslesung erfolgen. Bei derartigen bekannten magnetischen Messfühlem erfolgt diese Optimierungseinstellung über die Wahl der Schichtdicken der nichtmagnetischen Zwischenschichten. Die Schichtdicken sind jedoch nach der Herstellung der Schichtenpakete nicht mehr veränderbar, so dass eine nachträgliche Feinabstimmung nicht mehr möglich ist. Außerdem beschränkt diese Maßnahme den Einsatz der magnetischen Messfühler ausschließlich auf Anwendungen für Feldsensoren zur Ermittlung der magnetischen Feldstärke als einziger physikalischer Messgröße, da der magnetische Widerstand derartiger magnetischer Messfühler nur durch äußere Fremdmagnetfelder beeinflusst werden kann.

Das technische **Problem,** das der Erfindung zugrunde liegt, besteht darin, einen magnetischen Messfühler der eingangs beschriebenen Art so auszubilden, dass nach seiner Herstellung eine Veränderung seines internen Magnetwiderstandes zur anwendungsindividuellen Optimierung erfolgen kann. Weiterhin soll sich der Grundaufbau der Multischichtpakete für unterschiedliche Einsatzzwecke möglichst wenig unterscheiden. Die erfindungsgemäße **Lösung** hierzu ist dem Anspruch 1 zu entnehmen. Es hat sich in überraschender Weise gezeigt, dass die Veränderungen des internen Magnetwiderstandes durch Wasserstoffbeladung bei der angegebenen Schichtdicke wesentlich effektiver als bei anderen Schichtdicken ist.

Bei dem erfindungsgemäßen magnetischen Messfühler kann somit der Magnetwiderstand zu jedem Zeitpunkt nach der Fertigstellung des Schichtenpakets kontinuierlich und reversibel in weiten Grenzen (bis zum Dreifachen des Ausgangswerts) über die Konzentration der Wasserstoffbeladung der Zwischenschichten verändert werden. Dies ist z.B. für das Einsatzgebiet von Magnetfeldsensoren mit unterschiedlichen Empfindlichkeiten und/oder Grundeinstellungen von ausschlaggebender Bedeutung. Veränderungen, insbesondere Verschlechterungen der magnetischen Empfindlichkeit durch Alterung der Schichten, können durch eine erneute Wasserstoffbeladung ausgeglichen werden. Ebenso sind Überkorrekturen durch die Reversibilität der Wasserstoffbeladung durch eine Behandlung des Schichtenpakets bei reduziertem Wasserstoffpartialdruck kompensierbar.

Die Optimierung erfolgt bei der Erfindung über die Möglichkeit der kontinuierlichen und reversiblen Beeinflussung der Zwischenschichten durch die Wasserstoffbe- bzw. -entladung. Die Zwischenschichten bestehen dazu aus einem stark wasserstoffaffinen Material. Hierbei kann es sich um Nb oder um eine Legierung von Cr mit einem der stark wasserstoffaffinen Elemente V, Nb oder Ta handeln. Derartige Legierungen verfügen aufgrund der Cr-Komponente gegenüber Nb über einen grundsätzlich größeren Magnetwiderstand, wodurch die Empfindlichkeit des magnetischen Messfühlers noch verbessert werden kann. Zur Aktivierung der Beladung der Zwischenschichten mit Wasserstoff aus einem gasförmigen Wasserstoffstrom heraus ist bekannterweise die Anwesenheit eines Aktivierers (Katalysators), bei der Erfindung in Form einer Deckschicht des Schichtenpakets aus Pd, erforderlich. Diese Deckschicht schützt das Schichtenpaket gleichzeitig vor Oxidation.

Von ausschlaggebender Bedeutung für die kontinuierliche und reversible Veränderbarkeit des Magnetwiderstandes bei der Erfindung ist die Schichtdicke der Zwischenschichten. Bei nichtmagnetischen Zwischenschichten aus Nb mit einer Schichtdicke zwischen 1,3 nm und 1,6 nm kann eine effektive Veränderung der magnetischen Kopplung zwischen dem ferromagnetischen und dem antiferromagnetischen Zustand durch die Wasserstoffbeladung bewirkt werden. Bei nichtmagnetischen Zwischenschichten aus einer Legierung von Cr mit den Elementen V, Nb oder Ta liegt die Schichtdicke in einem größeren Bereich zwischen 0,8 nm und 2,3 nm. Hierdurch sind die elektronischen Eigenschaften bezüglich der antiferromagnetischen Kopplung vergleichbar zwischen Nb-Zwischenschichten und chromlegierten Zwischenschichten.

Durch die nachträgliche Feinabstimmbarkeit spielt eine sehr genaue Einhaltung der Schichtstärken keine wesentliche Rolle. Die Herstellungstoleranzen im Bereich sind deshalb relativ groß (beispielsweise in 0,3 nm-Schritten), so dass die Herstellung der einzelnen Schichten vereinfacht und die Ausschussrate verringert werden kann. Gleiches gilt für die Schichtstärken der einzelnen ferromagnetischen Schichten, deren Dicke im Regelfall zwischen 2 nm und 3 nm liegt. Die Auswirkung von Toleranzen der ferromagnetischen Schichten auf den Magnetwiderstand kann nachträglich durch die Feinabstimmung einfach ausgeglichen werden.

Der Einfluss der Schichtdicke der Zwischenschichten auf die Möglichkeit, durch eine Wasserstoffbeladung eine kontinuierliche und reversible Änderung der magnetischen Kopplung von einer antiferro- zu einer ferromagnetischen Kopplung erreichen zu können, wurde bislang in keiner der zitierten Veröffentlichungen beschrieben. Die theoretischen und experimentellen Arbeiten zur Thematik einer stufenweisen Veränderung der Dicke einer aus Nb bestehenden Zwischenschicht unter Wasserstoffbeladung als Grundlage für den erfindungsgemäßen magnetischen Messfühler können jedoch dem nachveröffentlichten Aufsatz in Phys. Rev. Lett. 78, No. 6 vom 10.02.97 von Klose et al., "Continous and reversible change of the magnetic coupling in an Fe/Nb multilayer induced by hydrogen charging" entnommen werden. In diesem Aufsatz sind auch weitere Einzelheiten zur Prozessführung angegeben.

Eine vorteilhafte Ausführung des Schichtaufbaus des erfindungsgemäßen magnetischen Messfühlers besteht darin, dass zwischen einem Substrat aus Si oder GaAs und einem Multischichtpaket mit ferromagnetischen Schichten aus Fe, Co, Ni, oder deren Legierungen eine Pufferschicht aus Cr vorgesehen ist. Diese Pufferschicht aus Cr wirkt als Diffusionsbarriere und verhindert so eine Vermischung von Substratmaterial mit Material aus dem Multischichtpaket. Damit wird eine Beeinflussung der magnetischen Eigenschaften des Multischichtpaketes durch Substratmaterial ausgeschlossen. Die Pufferschicht kann eine Dicke im Bereich von 5 nm aufweisen.

Grundsätzlich kann der erfindungsgemäße magnetische Messfühler sowohl durch äußere Magnetfelder als auch durch Wasserstoffzufuhr in seinem Magnetwiderstand verändert werden. Mit seiner Hilfe können daher zwei physikalisch völlig unterschiedliche Messgrößen (magnetische Feldstärke und Wasserstoffkonzentration) ermittelt werden. Diese Messgrößen können durch eine dem Messfühler zugeordnete 4-Pol-Widerstandsmeßanordnung ermittelt werden. Alle diese Messgrößen werden über die Ermittlung des durch sie beeinflussten elektrischen Widerstandes des Messfühlers bestimmt. Hierbei wird eine Ausgangsspannung in Abhängigkeit von einem konstanten, von einer Messelektronik vorgebbaren Strom in dieser 4-Pol-Widerstandsmeßanordnung gemessen. Für diese Anordnung wird der konstante Strom an zwei gegenüber liegenden Eckpunkten des Multischichtpaketes diesem aufgeprägt und die veränderliche Spannung an den anderen beiden Eckpunkten abgegriffen. Das Messsignal ist so für eine genaue Berechnung, beispielsweise in einer messwertverarbeitenden Computeranlage, des veränderlichen elektrischen Widerstandes ausreichend groß und genau.

Die Wasserstoffbeladung der Zwischenschichten kann reversibel erfolgen, d.h. eingelagerter Wasserstoff kann auch wieder aus den Zwischenschichten ausgasen. Befindet sich der erfindungsgemäße magnetische Messfühler in einer offenen Atmosphäre, kann er deshalb bevorzugt als magnetischer Messfühler für Wasserstoffgas benutzt werden. Seine Umspülung mit einem Wasserstoffgasstrom bewirkt eine Zunahme des eingelagerten Wasserstoffanteils und damit eine Veränderung des Magnetwiderstandes bzw. des elektrischen Widerstandes des magnetischen Messfühlers. Diese angezeigte Veränderung ist also das Maß für die Wasserstoffkonzentration in der Umgebung des magnetischen Messfühlers. Derartige Messungen können dynamisch mit ständig wechselnden Konzentrationen oder statisch in einem konstanten Wasserstoffumfeld erfolgen. Liegen die Messungen längere Zeit auseinander, nimmt der magnetische Messfühler automatisch eine Nullstellung bei normaler Umgebungsluft durch Ausgleich der Wasserstoffpartialdrücke in den Zwischenschichten und in der Umgebungsluft ein. Eine derartige Anwendungsmöglichkeit erweitert die Einsatzpalette des erfindungsgemäßen magnetischen Messfühlers in eine völlig neue Richtung und ist bei den bekannten magnetischen Messfühlem nicht gegeben.

Der Magnetwiderstand ist definiert als Differenz des elektrischen Widerstandes des magnetischen Messfühlers zwischen den Zuständen mit und ohne Einwirkung eines äußeren Magnetfeldes. Er ist damit temperaturunabhängig und reagiert sehr empfindlich auf Schwankungen der Wasserstoffkonzentration in seiner Umgebung. Liegt kein äußeres Magnetfeld an, drücken sich diese Schwankungen in einer reinen Widerstandsänderung des Sensors aus, die ohne weiteres ermittelbar ist. Will man jedoch die Änderungen der Wasserstoffkonzentration der jeweiligen Magnetwiderstandsänderung zuordnen, ist es besonders vorteilhaft, wenn Veränderungen seines Magnetwiderstandes unter Aufprägung eines äußeren, durchstimmbaren Magnetfeldes bestimmt werden können. Bei Durchfahren des äußeren Magnetfeldes wird dann die entsprechende Änderung des elektrischen Widerstandes aufgezeigt und der zugehörigen, aktuell zu bestimmenden Wasserstoffkonzentration zugeordnet.

Bildet hingegen ein äußeres magnetisches Feld die physikalische Messgröße, wird also der erfindungsgemäße magnetische Messfühler als Magnetfeldsensor eingesetzt, ist hierfür die Konstanthaltung und Fixierung des Wasserstoffgehalts in den Zwischenschichten die Voraussetzung. Es ist hierbei besonders vorteilhaft, wenn der magnetische Messfühler innerhalb einer magnetisch abschirmenden Kapselung angeordnet ist, die ein wasserstoffundurchlässiges Magnetfeldfenster aufweist. Der Wasserstoffgehalt in den Zwischenschichten ist durch diese Kapselung von Umwelteinflüssen unabhängig, so dass auch der magnetische Widerstand des magnetischen Messfühlers in der Grundeinstellung zuverlässig konstant ist. Ein Ausgleich der Wasserstoff-Partialdrücke zwischen dem Kapselungsinneren und der Umgebung kann aufgrund der Wasserstoffundurchlässigkeit des Magnetfeldfensters nicht stattfinden. Die zu messenden äußeren magnetischen Felder können dann auf den magnetischen Messfühler nur durch das Magnetfeldfenster einwirken und zu einer Änderung des magnetischen bzw. elektrischen Widerstandes des magnetischen Messfühlers führen. Fremdeinwirkungen durch Störfelder sind sicher vermieden. Eine derartige Kapselung kann beispielsweise aus einer weichmagnetischen NiFe-Legierung (Permalloy) bestehen.

Der magnetische Messfühler in der Anwendung zur Detektion von magnetischen Feldstärken weist im allgemeinen ein ebenes Multischichtpaket auf, das durch Abscheidung der jeweiligen Schichtenmaterialien aus der Gasphase auf einem ebenen Substrat aufgezogen wurde. In dieser Ausgestaltung kann er von einer Kapselung eng umschlossen sein. Der Messfühler kann aber auch gemäß einer weiteren Erfindungsausgestaltung ringförmig ausgebildet und mit einem Luftspalt versehen sein, der mit dem Magnetfeldfenster in der Kapselung fluchtet.

Durch die dadurch erreichte kompakte Bauform, bei der die Kapselung ebenfalls ringförmig das Multischichtpaket umschließen kann, und die Bündelung des Magnetfeldes im Luftspalt ist er besonders zum Einsatz als hochpräziser Lesekopf bei der magnetischen Informationsverarbeitung geeignet. Die Herstellung eines aus konzentrischen Ringen bestehenden Multischichtpakets aus der Gasphase auf einem beispielsweise stabförmigen Substrat ist zum gegenwärtigen Zeitpunkt jedoch noch sehr schwierig.

Ein Multischichtpaket weist typischerweise bei einer Grundfläche im Bereich von 5 mm x 5 mm eine Pakethöhe ohne Substrat von bis zu 100 nm auf, was einer mittleren Lagenanzahl von 10 bis 20 Doppellagen entsprechen kann. Für Anwendungen in der Mikroelektronik können die lateralen Dimensionen des magnetischen Messfühlers jedoch auch sehr viel kleiner als 1 mm sein, ohne dass seine Wirkungsweise eingeschränkt ist.

Die Erfindung wird nachfolgend an Ausführungsbeispielen anhand der zugehörigen Zeichnung in perspektivischer, aber maßstabsverzerrter Darstellung näher erläutert. Es zeigen:
- **Figur 1**: einen erfindungsgemäßen magnetischen Messfühler in einer Ausführungsform als Wasserstoff-Detektor
und
- **Figur 2**: einen erfindungsgemäßen magnetischen Messfühler in einer Ausführung als Magnetfeldsensor.

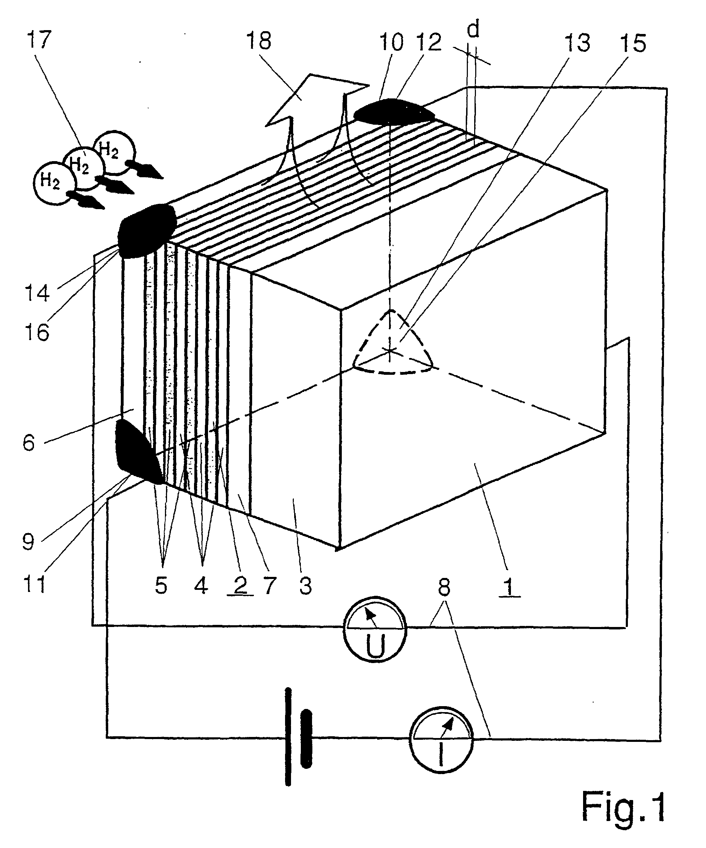

In **Figur 1** ist ein magnetischer Messfühler **1** zur Detektion von Wasserstoffkonzentrationen dargestellt. Der magnetische Messfühler **1** befindet sich in freier Umgebung und weist ein magnetisches Multischichtpaket **2** auf, das auf einem Si - Substrat **3** (Dicke 100 nm) angeordnet ist. Das Multischichtpaket **2** besteht aus miteinander abwechselnden ferromagnetischen Schichten **4** und nichtmagnetischen Zwischenschichten **5.** Die ferromagnetischen Schichten **4** sind im gewählten Ausführungsbeispiel 2,6 nm dick und bestehen aus Fe. Die nichtmagnetischen Zwischenschichten **5** weisen dagegen im Beispiel eine Schichtdicke **d** von 1,5 nm auf und bestehen aus dem stark wasserstoffaffinen Übergangsmetall Nb. Zur Wasserstoffaktivierung ist das Multischichtpaket **2** mit einer Pd - Deckschicht 6 (Dicke 5 nm) versehen. Zwischen dem Substrat 3 und dem Multischichtpaket 2 ist zur Diffusionsverhinderung eine Pufferschicht **7** aus Cr (Dicke 5 nm) vorgesehen.

Die Magnetwiderstandsänderung ist im dargestellten Ausführungsbeispiel unter der verändernden Wirkung eines äußeren, durchstimmbaren Magnetfeldes **18** (in der Figur angedeutet durch einen breiten Pfeil) als Maß für die zu messende Größe, hier die Konzentration von Wasserstoff, ermittelbar. Dazu weist der magnetische Messfühler **1** eine 4-Pol-Widerstandsmeßanordnung **8** auf. Diese verfügt über zwei Kontaktstellen **9** und **10** an den diagonal gegenüberliegenden Ecken **11** und **12** des Multischichtpakets **2** zur Aufprägung eines konstanten Stromes **I**, der von einer nicht weiter dargestellten Messelektronik vorgegeben wird. Als Ausgangssignal wird eine Spannung **U** an zwei weiteren, diagonal gegenüberliegenden Kontaktstellen **13** und **14** an den beiden anderen Ecken **15** und **16** des Multischichtpakets **2** abgegriffen. Aus den beiden Größen **I** und U kann der durch die zu ermittelnde physikalische Größe veränderbare elektrische Widerstand im Magnetfeld des Multischichtpakets **2** von einer ebenfalls nicht weiter dargestellten Recheneinheit berechnet werden. Gegenüber dem in Fig. 1 dargestellten diagonalen Abgriff der Spannung **U** am Multischichtpaket **2** ist auch eine Ausführung denkbar, bei der der Strom **I** an den beiden oberen Kontaktstellen aufgeprägt wird und der Abgriff der Spannung U an den beiden unteren Kontaktstellen des Multischichtpakets erfolgt.

Die mit dem magnetischen Messfühler **1** zu messende Größe ist hier die Konzentration eines Wasserstoffgasstromes **17,** der den magnetischen Messfühler **1** frei umspült. Durch Einlagerung und Ausgasung von Wasserstoff in bzw. aus den stark wasserstoffaffinen Nb-Zwischenschichten **5** ist die magnetische Kopplung zwischen den ferromagnetischen Fe-Schichten **4** kontinuierlich und reversibel veränderbar. Dadurch kann eine Veränderung des Magnetwiderstandes bewirkt werden, der unter Einfluss des äußeren durchstimmbaren Magnetfeldes **18,** das beispielsweise von einem entsprechend angeordneten und ausgerüsteten Permanentmagneten erzeugt wird, einer Änderung des elektrischen Widerstandes zuordenbar ist. Die Messungen können dynamisch bei ständig wechselnder Wasserstoffkonzentration oder statisch in einer konstanten Wasserstoffatmosphäre erfolgen. Wird kein Messwert abgefragt, stellt sich der magnetische Messfühler **1** durch den Ausgleich der Wasserstoffpartialdrücke in den Zwischenschichten **5** und der Umgebung selbsttätig auf eine Nullstellung ein.

Vorteilhafterweise ist der Wasserstoff-Detektor durch eine nicht gezeigte Ummantelung, beispielsweise mit einer weichmagnetischen Folie, von magnetischen Feldern abgeschirmt.

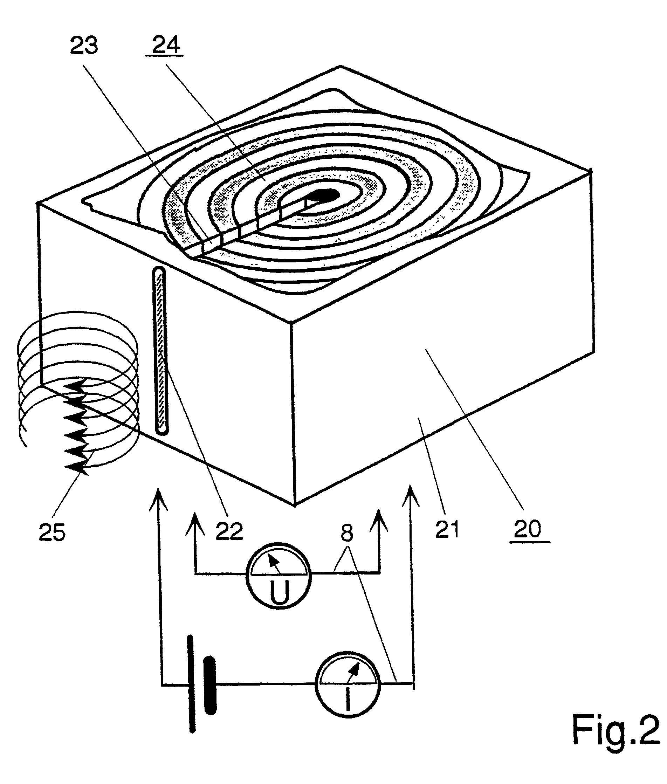

Die **Figur 2** zeigt eine Ausführungsform des erfindungsgemäßen magnetischen Messfühlers **20** als Magnetfeldsensor. Diese Ausführungsform unterscheidet sich in ihrem Aufbau konstruktiv von dem magnetischen Messfühler **1** gemäß Figur 1 dadurch, dass er mit einer magnetisch abschirmenden Kapselung **21** versehen ist, die ein wasserstoffundurchlässiges Magnetfeldfenster **22** aufweist und als ringförmiges Multischichtpaket **24** ausgebildet ist. Mit dem Magnetfeldfenster fluchtet ein Luftspalt **23.** Das Innere der Kapselung **21** (aufgebrochen dargestellt) ist wasserstoffundurchlässig abgeschlossen, so dass keine Wasserstoffdiffusion zwischen der Umgebung und dem ringförmig ausgebildeten Multischichtpaket **24** auftreten kann. Der bei der Herstellung auf den Anwendungsfall durch Wasserstoffbeladung feinabgestimmte Magnetwiderstand des magnetischen Messfühlers **20** bleibt so über einen langen Zeitraum konstant. Bei Alterung der Schichten und damit Verschlechterung der magnetischen Eigenschaften kann das Multischichtpaket **24** jedoch separat erneut mit Wasserstoffgas behandelt und auf den ursprünglichen Magnetwiderstandswert eingestellt werden.

Die mit diesem magnetischen Messfühler **20** zu messende physikalische Messgröße ist die magnetische Feldstärke eines äußeren Fremdmagnetfeldes **25,** beispielsweise die unterschiedlichen Magnetisierungen auf einem magnetischen Datenträger. Dieses äußere Fremdmagnetfeld wirkt über das wasserstoffundurchlässige Magnetfeldfenster **22** auf das im Luftspalt **23** konzentrierte Magnetfeld des Multischichtpakets **24** ein und erzielt damit eine entsprechende Änderung seines elektrischen Widerstands, der beim Fließen des konstanten Stroms **I** wieder durch die Messung der Spannung **U** ermittelt werden kann (in der Figur ist die Schaltungsanordnung **8** angedeutet). Dabei kann das Fremdmagnetfeld **25** zeitlich veränderlich oder konstant sein. Derartige Magnetfeldsensoren **20** können alle Aufgaben bisher bekannter Feldsensoren, insbesondere die Aufgaben in Leseköpfen jeglicher Bauart, vollständig übernehmen. Sie sind durch ihre einfache nachträgliche Feinabstimmbarkeit über die Wasserstoffbetadung der Zwischenschichten darüber hinaus in bisher nicht gekannter Möglichkeit optimal an den jeweiligen Anwendungsfall anpassbar.

### Bezugszeichenliste

- 1: magnetischer Meßfühler
- 2: Multischichtpaket
- 3: Substrat
- 4: ferromagnetische Schicht
- 5: nichtmagnetische Zwischenschicht
- 6: Deckschicht
- 7: Pufferschicht
- 8: 4-Pol-Widerstandsmeßanordnung
- 9: 1. Kontaktstelle für Stromaufprägung
- 10: 2. Kontaktstelle für Stromaufprägung
- 11: 1. Ecke des Multischichtpakets 2
- 12: 3. Ecke des Multischichtpakets 2
- 13: 1. Kontaktstelle für Spannungsabgriff
- 14: 2. Kontaktstelle für Spannungsabgriff
- 15: 2. Ecke des Multischichtpakets 2
- 16: 4. Ecke des Multischichtpakets 2
- 17: Wasserstoffgasstrom
- 18: äußeres durchstimmbares Magnetfeld
- d: Dicke der nichtmagnetischen Zwischenschichten 5
- 20: magnetischer Meßfühler - Magnetfeldsensor
- 21: magnetisch abschirmende Kapselung
- 22: wasserstoffundurchlässiges Magnetfeldfenster
- 23: Luftspalt
- 24: ringförmiges Multischichtpaket
- 25: äußeres Fremdmagnetfeld

## Patentansprüche

1. Magnetischer Messfühler mit durch Wasserstoffbeladung definiert veränderbarem internen, die Differenz des elektrischen Widerstandes bei angelegtem und abgeschaltetem Magnetfeld charakterisierenden Magnetwiderstand, bestehend aus einem Multischichtpaket (2) jeweils sich abwechselnder ferromagnetischer Schichten (4) und wasserstoffaffiner nichtmagnetischer Zwischenschichten (5) auf einem Substrat (3), wobei die Schichten (4) und die Zwischenschichten (5) magnetisch durch den Austausch spinpolarisierter Elektronen gekoppelt sind, und einer Deckschicht (6) aus Pd zur Wasserstoffaktivierung, wobei die nichtmagnetischen Zwischenschichten (5) entweder aus Nb mit einer Schichtdicke (d) zwischen 1,3 nm und 1,6 nm oder aus einer Legierung von Cr mit den Elementen V, Nb oder Ta mit einer Schichtdicke (d) zwischen 0,8 nm und 2,3 nm bestehen.

2. Magnetischer Messfühler nach Anspruch 1,
**dadurch gekennzeichnet, dass**
das Substrat (3) aus Si oder GaAs besteht,
dass die ferromagnetischen Schichten (4) des Multischichtpakets (2) aus Fe, Co oder Ni oder deren Legierungen bestehen, und
dass zwischen dem Substrat (3) und dem Multischichpaket (2) eine Pufferschicht (7) aus Cr vorgesehen ist.

3. Magnetischer Messfühler nach Anspruch 1 oder 2,
**dadurch gekennzeichnet, dass**
dieser als Wasserstoff-Detektor oder als Magnetfeldsensor ausgebildet und demselben eine 4-Pol-Meßbrücke zur Messung der Magnetwiderstandsänderung zur Ermittlung der jeweiligen Messgröße zugeordnet ist.

4. Magnetischer Messfühler nach Anspruch 3,
**dadurch gekennzeichnet, dass**
dieser (1) als Wasserstoff-Detektor ausgebildet und in einem äußeren durchstimmbaren Magnetfeld (18) angeordnet ist, in dem Veränderungen seines Magnetwiderstandes bestimmbar sind.

5. Magnetischer Messfühler nach Anspruch 3,
**dadurch gekennzeichnet, dass**
dieser (20) als Magnetfeldsensor ausgebildet und innerhalb einer magnetisch abschirmenden Kapselung (21) angeordnet ist, die ein wasserstoffundurchlässiges Magnetfeldfenster (22) aufweist.

6. Magnetischer Messfühler nach Anspruch 5,
**dadurch gekennzeichnet, dass**
der Magnetfeldsensor (20) ringförmig ausgebildet und mit einem Luftspalt (23) versehen ist, der mit dem wasserstoffundurchlässigen Magnetfeldfenster (22) in der Kapselung (21) fluchtet.

## Claims

1. Magnetic sensor with a variable internal magnetic resistance, defined by hydrogen loading, **characterising** the difference of the electrical resistance under an applied and disconnected magnetic field, consisting of a multilayer packet (2) of alternating ferromagnetic layers (4) and non-magnetic intermediate layers (5) having an affinity for hydrogen on a substrate (3), wherein the layers (4) and the intermediate layers (5) are magnetically coupled by the exchange of spin-polarised electrons, and a cover layer (6) of Pd for hydrogen activation, wherein the non-magnetic intermediate layers (5) consist either of Nb with a layer thickness (d) between 1.3 nm and 1.6 nm or of an alloy of Cr with the elements V, Nb or Ta with a layer thickness (d) between 0.8 nm and 2.3 nm.

2. Magnetic sensor according to claim 1, **characterised in that** the substrate (3) consists of Si or GaAs, that the ferromagnetic layers (4) of the multilayer packet (2) consist of Fe, Co or Ni or their alloys, and that a buffer layer (7) of Cr is provided between the substrate (3) and the multilayer packet (2).

3. Magnetic sensor according to claim 1 or 2, **characterised in that** this is formed as an hydrogen detector or magnetic field sensor and a 4-pole measuring bridge is associated with the latter for measuring the change in magnetic resistance in order to determine the respective measurement quantity.

4. Magnetic sensor according to claim 3, **characterised in that** this (1) is formed as an hydrogen detector and is arranged in an external tuneable magnetic field (18) in which changes in its magnetic resistance can be determined.

5. Magnetic sensor according to claim 3, **characterised in that** this (20) is formed as a magnetic field sensor and is arranged within a magnetically screenable capsule (21) that comprises an hydrogen-impermeable magnetic field window (22).

6. Magnetic sensor according to claim 5, **characterised in that** the magnetic field sensor (20) is of annular shape and is provided with an air gap (23) that is in alignment with the hydrogen-impermeable magnetic field sensor (22) in the capsule (21).

## Revendications

1. Capteur magnétique présentant une résistance magnétique pouvant varier de manière définie par la charge en hydrogène, caractérisant la différence de la résistance électrique quand le champ magnétique est appliqué ou coupé, ce capteur étant composé d'un paquet multicouches (2) alternant des couches ferromagnétiques (4) et des couches intermédiaires (5) non magnétiques ayant de l'affinité pour l'hydrogène et déposées sur un substrat (3), les couches (4) et intermédiaires (5) étant couplées magnétiquement par l'échange d'électrons à spin polarisé, et d'une couche de couverture (6) en Pd pour activer l'hydrogène, les couches intermédiaires (5), non magnétiques étant en Nb avec une épaisseur de couche (d) comprise entre 1,3 nm et 1,6 nm, ou en un alliage du Cr avec les éléments V, Nb ou Ta, l'épaisseur (d) de la couche étant comprise entre 0,8 nm et 2,3 nm.

2. Capteur magnétique selon la revendication 1,
**caractérisé en ce que**
- le substrat (3) est en Si ou en GaAs,
- les couches ferromagnétiques (4) du paquet multicouches (2) sont en Fe, Co, Ni ou en alliages de ces éléments,
- entre le substrat (3) et le paquet multicouches (2) il est prévu une couche tampon (7) en Cr.

3. Capteur magnétique selon la revendication 1 ou 2,
**caractérisé en ce qu'**
il est constitué pour servir de détecteur d'hydrogène ou de capteur de champ magnétique et il lui est associé un pont de mesure à quatre pôles pour mesurer la variation de la résistance magnétique afin de déterminer la grandeur à mesurer.

4. Capteur magnétique selon la revendication 3,
**caractérisé en ce qu'**
il est constitué comme détecteur d'hydrogène et il est monté dans un champ magnétique (18) externe ajustable dans lequel on peut déterminer les variations de sa résistance magnétique.

5. Capteur magnétique selon la revendication 3,
**caractérisé en ce qu'**
il est constitué (20) comme capteur de champ magnétique et il est monté à l'intérieur d'un encapsulage (21) formant écran magnétique et qui présente une fenêtre de champ magnétique (22) imperméable à l'hydrogène.

6. Capteur magnétique selon la revendication 5,
**caractérisé en ce que**
le capteur de champ magnétique (20) a une forme annulaire et présente une fente d'air (23) alignée avec la fenêtre de champ magnétique (22) imperméable à l'hydrogène, prévue dans l'encapsulage (21).
